**Europäisches Patentamt**

**European Patent Office**

**Office européen des brevets**

(19)

(11) Veröffentlichungsnummer: **0 474 089 A2**

## (12) EUROPÄISCHE PATENTANMELDUNG

(21) Anmeldenummer: **91114295.8**

(22) Anmeldetag: **26.08.91**

(51) Int. Cl.5: **G01R 15/12**

(30) Priorität: **01.09.90 DE 4027803**

(43) Veröffentlichungstag der Anmeldung:
**11.03.92 Patentblatt 92/11**

(84) Benannte Vertragsstaaten:
**DE FR GB IT NL**

(71) Anmelder: **ABB PATENT GmbH**
**Kallstadter Strasse 1**
**W-6800 Mannheim 31(DE)**

(72) Erfinder: **Henkelmann, Dieter**
**Julius-Leber-Strasse 82**
**W-8500 Nürnberg 50(DE)**

(74) Vertreter: **Rupprecht, Klaus, Dipl.-Ing. et al**
**c/o ABB Patent GmbH, Patentabteilung,**
**Postfach 10 03 51**
**W-6800 Mannheim 1(DE)**

(54) **Multimeter mit einem Messbereichsschalter.**

(57) 2.1. Bei Multimetern zum wahlweisen Messen unterschiedlicher Meßgrößen, deren Meßsignale über verschiedene, jeweils einer bestimmten Meßgröße zugeordnete Eingangskreise vom Multimeter erfaßt werden, kann ein Eingangskreis angeschlossen werden, der für die am Meßbereichsschalter eingestellte Eingangsgröße nicht geeignet ist.

2.2. Um den Bedienenden zumindest auf den von ihm verursachten Fehler aufmerksam zu machen, ist mindestens ein Hilfskreis (H6, H7) gebildet und so über den Meßbereichsschalter (S) geführt, daß sich eine feste, von dessen Schaltstellung abhängige Zuordnung zu einem bestimmten Eingangskreis (a, b) und damit zu einer bestimmten Meßgröße (A, B) ergibt. In den Hilfskreis (H6, H7) ist mindestens ein Funktionsgeber (M6, M7) eingefügt, der bei Betätigung, die vorzugsweise durch Schließen des Hilfskreises (H6, H7) erreicht wird, eine Funktion oder eine Kombination aus mehreren Funktionen auslöst. Hierdurch wird dem Bedienungsfehler beim Umschalten der Meßgröße (A, B) entgegengewirkt.

Fig.1

Die Erfindung betrifft ein Multimeter der im Oberbegriff des Anspruchs 1 genannten Art.

Multimeter bieten die Möglichkeit, eine Vielzahl von Meßgrößen, insbesondere Spannungen, Ströme und Widerstände mit demselben Gerät zu messen. Die Meßschaltungen, die zur Erfassung der verschiedenen Meßgrößen benötigt werden, unterscheiden sich zum Teil ganz erheblich, was bedeutet, daß für die unterschiedlichen Meßgrößen auch unterschiedliche Eingangskreise für die Messung zur Verfügung stehen müssen.

Wegen ihrer vielseitigen Anwendbarkeit erfreuen sich Multimeter nicht nur in Laboratorien und Werkstätten, sondern auch bei Bastlern großer Beliebtheit. Die Vielseitigkeit der Multimeter birgt allerdings auch Gefahren.

So ist es wichtig, daß vor jeder Messung der richtige, der zu untersuchenden Meßgröße zugeordnete Eingangskreis angeschlossen wird. Soll z.B. die Netzspannung gemessen werden und bleibt versehentlich der Eingangskreis eingeschaltet, der zur Messung von Strömen vorgesehen ist, so kann das für das Multimeter, bisweilen sogar für den Bedienenden, schwerwiegende Folgen haben, wenn die Netzsicherung nicht schnell genug abschaltet. Die im Multimeter vorgesehene Gerätesicherung reicht in aller Regel nicht aus, um das Multimeter von einer energiereichen Spannungsquelle zu trennen, da der beim Öffnen des Stromkreises auftretende Lichtbogen die Gerätesicherung überbrücken kann.

Ähnliche Probleme und Gefahren können auch bei anderen Kombinationen, bei denen eine Meßgröße auf einen falschen Eingangskreis trifft, für das Meßobjekt, das Multimeter und den Bedienenden entstehen. Doch selbst dann, wenn aus einem Bedienungsfehler keine unmittelbare Gefahr resultiert, kann es immer noch zu einer mittelbaren Gefährdung kommen, wenn z.B. die Anzeige des Multimeters das Fehlen einer zu prüfenden Spannung vortäuscht, weil ein Eingangskreis angeschlossen wurde, der gerade außer Betrieb, also nicht mit dem Meßsystem verbunden war. Durch die vorgetäuschte Spannungsfreiheit wird der Bedienende bisweilen zu ihn gefährdenden Handlungen verleitet.

Worauf zu achten ist, damit es bei einem Multimeter nicht zu derartigen Fehlbedienungen kommt, hängt vom Aufbau dieses Gerätes ab. Bei vielen Multimetern besitzen die verschiedenen Eingangskreise einen allen Eingangskreisen gemeinsamen ersten Eingangsanschluß und einen eigenen dem jeweiligen Meßkreis zugeordneten, mit der zugehörigen Meßgröße korrespondierenden zweiten Eingangsanschluß. In der Regel gehören zu jeder Meßgröße wiederum mehrere Meßbereiche z.B. zur Meßgröße "Spannung" die Meßbereiche 1, 3, 10, 30V usw. Der Eingangskreis besitzt in diesem Fall einen Spannungsteiler, an dem alle Spannungen auf Werte herabgeteilt oder auch durch Verstärkung erhöht werden, damit an das Meßsystem angepaßte Werte zur Verfügung stehen.

Für das Umschalten des Spannungsteilers auf einen gewünschten Spannungsmeßbereich bzw. das Umschalten von Shunts auf einen gewünschten Strommeßbereich verwendet man einen Meßbereichsschalter. Bei der Bedienung des Meßgerätes muß man also dafür sorgen, daß der Meßbereichsschalter auf die Meßgröße gestellt wird, die gemessen werden soll. Gleichzeitig ist aber darauf zu achten, daß eingangsseitig am Multimeter die Meßleitungen mit den richtigen Eingangsanschlüssen und dadurch mit dem richtigen Eingangskreis verbunden werden.

Es liegt auf der Hand, daß bei weniger konzentriertem Arbeiten, besonders auch durch Nichtfachleute, einer der beiden Bedienhandgriffe vergessen werden kann und dann entweder der falsche Eingangskreis angeschlossen, oder ein falscher Meßbereich eingeschaltet wird.

Selbstverständlich hat man versucht, mit zusätzlichen Sicherungsmaßnahmen die Gefahren einer Fehlbedienung in Grenzen zu halten. Die verwendeten Schutzschaltungen arbeiten mit passiven und aktiven Schaltern, Relaisschaltern, gesteuerten Halbleiterschaltern, mit Transistoren und Thyristoren sowie Schmelzsicherungen besonderer Bauart. Trotz des teilweise recht hohen Aufwandes gelingt es mit bisherigen Techniken jedoch keineswegs immer, leistungsstarke Spannungsquellen innerhalb des kleinen, bei modernen Multimetern zur Verfügung stehenden Raumes im Fehlerfall sicher abzuschalten. Eine Verminderung der Gefahren läßt sich somit nur erzielen, wenn die Fehlbedienung weitgehend ausgeschlossen wird.

Es wurde versucht, diese Aufgabe dadurch zu lösen, daß man das Umstecken der Meßleitungen durch Umschalten der Eingangskreise ersetzte. Hierdurch wurde zwar die Bedienung des Meßgerätes etwas erleichtert, aber das Problem nicht beseitigt. So kann das Umschalten der Eingangskreise entweder durch einen zusätzlichen Eingangskreisschalter geschehen oder durch den Meßbereichsschalter zusätzlich übernommen werden. Ein zusätzlicher Eingangskreisschalter verlagert das Problem lediglich auf ein anderes Bauteil, da nun mit gleicher Aufmerksamkeit darauf geachtet werden muß, daß sowohl der Eingangskreisschalter als auch der Meßbereichsschalter auf die zu untersuchende Meßgröße gestellt wurden. Demgegenüber bedeutet eine Zusammenfassung aller Schaltfunktionen am Meßbereichsschalter, daß dieser in der Lage sein muß, außer sehr kleinen auch große Leistungen zu schalten, was wiederum eine erhebliche Verteuerung dieses Bauelements zu Folge hat. Außerdem ist zu bedenken, daß die hierdurch erreichte Verminderung der Zahl der Bedienelemente nicht zwangsläufig die Bedienung wesentlich sicherer macht, denn auch ein einziger Schalter kann immer noch in eine falsche Schaltstellung gebracht werden, was dann zwangsläufig zum Anschluß auch eines falschen Eingangskreises mit entsprechenden Folgen führt. Insofern kann der Zwang, auf die richtige Stellung von zwei Bedienelementen achten zu müssen, zu einer erhöhten Aufmerksamkeit führen.

Aufgabe der Erfindung ist es, ein Multimeter nach dem Oberbegriff des Anspruches 1 zu schaffen, bei dem die Gefahr einer Fehlbedienung wesentlich vermindert ist, so daß nur ein solcher Eingangskreis mit dem Meßsignal verbunden wird, dem die mit dem Meßbereichsschalter eingestellte Meßgröße zugeordnet ist.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Durch die Kopplung eines Hilfskreises mit dem Meßbereichsschalter derart, daß sich eine feste, von dessen Schaltstellung abhängige Zuordnung zu einem bestimmten Eingangskreis und damit zu einer bestimmter Meßgröße ergibt, ist es möglich, über diesen Hilfskreis einen Funktionsgeber zu aktivieren, der eine Funktion auslösen kann, die den Benutzer auf Bedienfehler aufmerksam macht, oder diese Bedienfehler sogar verhindert.

Die aus einem oder mehreren Hilfskreisen mit zugehörigen Funktionsgebern bestehende Schutzschaltung wird bezüglich der Sicherheit, die sie bietet einerseits, aber auch bezüglich des technischen Aufwandes andererseits wesentlich durch die verwendeten Funktionsgeber bestimmt. So ist in einer Weiterbildung der Erfindung vorgesehen, als Funktionsgeber einen Stellungsgeber, vorzugsweise einen Magnetsteller einzusetzen, wobei dieser zum Ein- und Ausschalten bestimmter Schalter und/oder zur Arretierung, insbesondere des Meßbereichsschalters, und/oder zur Betätigung eines Sperriegels verwendet werden kann.

Zum Schutz des jeweiligen Eingangskreises kann der Magnetsteller einen Eingangskreisschalter so steuern, daß dieser nur eingeschaltet werden kann, wenn ein solcher Eingangsanschluß durch die Meßleitung kontaktiert wird, dem genau die mit dem Meßbereichsschalter vorgegebene Meßgröße zugeordnet ist. Der Magnetsteller wird hierzu durch einen Hilfskreis gesteuert, der sich nur schließt, wenn einerseits eine zum Meßbereichsschalter gehörige Schaltstrecke und andererseits ein in den Eingangsanschluß integrierter Kontaktgeber geschlossen werden. Dabei schließt sich der Kontaktgeber sobald der vorzugsweise als Steckbuchse ausgebildete Eingangsanschluß durch eine mit einem Stecker versehene Meßleitung kontaktiert wird. Geeignete Isolierteile sorgen dafür, daß der Hilfskreis vom Eingangskreis elektrisch getrennt bleibt.

Weiterhin ist vorgesehen, daß der Magnetsteller außer dem Eingangskreisschalter auch einen Hilfsschalter betätigt und beim Ansprechen des Magnetstellers durch Anschließen einer Meßleitung, der Hilfsschalter einen Signalgeber, vorzugsweise einen Summer einschaltet, so daß dieser ein Signal abgibt, wenn sich der Eingangskreisschalter bei angeschlossener Meßleitung nicht schließt. Da letzteres ein Zeichen dafür ist, daß mit dem Meßbereichsschalter eine andere Meßgröße als durch Anschließen der Meßleitung vorgegeben wurde, kann der Benutzer des Multimeters seinen Bedienungsfehler korrigieren.

Eine gegebenenfalls vom gleichen Magnetsteller ebenfalls ausgelöste Arretierung des Meßbereichsschalters schützt diesen vor einem unbeabsichtigten Umschalten, solange ein Eingangskreis geschlossen ist. Das bedeutet, daß der Eingangskreis durch Entfernen der Meßleitung vom Eingangsanschluß geöffnet werden muß und dadurch stromlos wird, bevor der Meßbereichsschalter umgeschaltet werden kann und sich dann auch der Eingangskreisschalter öffnet. Ein Öffnen des Eingangskreisschalters bei Last wird dadurch vermieden. Auch wird der Benutzer nunmehr gezwungen, die Meßleitung nach dem Umschalten des Meßbereichsschalters mit dem zugehörigen richtigen Eingangsanschluß zu verbinden.

Zur Gestaltung der Arretierelemente ergeben sich vielfältige Lösungsmöglichkeiten, die jedoch in der Regel darauf hinauslaufen, daß ein erstes Arretierelement an einem zweiten, am beweglichen Teil des Meßbereichsschalters ausgebildeten Arretierelement angreift, wobei die Arretierelemente so positioniert sind, daß nach erfolgtem Eingriff ein Umschalten der Meßbereiche mit den Meßbereichsschalter nur noch im Bereich der gerade eingestellten Meßgröße möglich ist. Es soll somit keine vollständige Arretierung des Meßbereichsschalters vorgenommen werden, sondern lediglich ein Umschalten von einer Meßgröße auf eine andere verhindert werden.

Anstelle eines Eingangskreisschalters, der den Eingangskreis zum Sperren unterbricht, ist es auch möglich, mit einem vom Magnetsteller betätigten Sperriegel zu arbeiten, der in mindestens einen der Eingangsanschlüsse eingebaut ist und im Falle seines Auslösens ein Kontaktieren des jeweiligen Eingangsanschlusses mit der Meßleitung verhindert.

Baut man zusätzlich zu dem Sperriegel noch einen Kontaktgeber in den Eingangsanschluß ein, so ist es möglich, durch diesen Kontaktgeber, der sich beim Anstecken einer Meßleitung schließt, einen Magnetsteller zu aktivieren, der eine Arretierung auslöst, die den Meßbereichsschalter arretiert und bewirkt, daß dieser bei angeschlossener Meßleitung nicht auf eine andere Meßgröße umgeschaltet werden kann. Es ist also auch bei dieser Art der Schutzschaltung Vorsorge getroffen, daß durch den Sperriegel nur der Eingangsanschluß konntaktiert werden kann, dem die mit dem Meßbereichsschalter eingestellte Meßgröße zugeordnet ist, und die Arretierung ein Umschalten des Meßbereichsschalters nur erlaubt, wenn die Meßleitung wieder vom jeweiligen Eingangsanschluß entfernt wurde.

An die Stelle mehrerer Eingangsanschlüsse, zum Kontaktieren unterschiedlicher Eingangskreise kann, wie bereits erwähnt, auch ein Eingangskreisschalter treten, der die Bedienung des Multimeters erleichtert, da das Umstecken der Meßleitungen entfällt. So ist es möglich, einen von Hand betätigbaren Eingangskreisschalter mit einem in einem Hilfskreis liegenden Hilfskreisschalter zu koppeln und beide Schalter so aufzubauen, daß sie von einer Nullstellung aus, je nach Schaltrichtung, auf eine andere Meßgröße schaltbar sind. Bei diesem Umschaltvorgang muß der Hilfskreisschalter jedoch gegenüber dem Eingangskreisschalter soweit vorauseilen, daß ein im Hilfskreis liegender Magnetsteller über eine Arretierung den von Hand betätigbaren Eingangskreisschalter vor einem Einschalten sperren kann, sofern der Meßbereichsschalter auf einer anderen Meßgröße steht, als über den Eingangskreisschalter eingestellt werden soll.

Um auch bei dieser Schutzschaltung zu verhindern, daß der Meßbereichsschalter bei eingeschaltetem Eingangskreisschalter umgeschaltet werden kann, ist wiederum ein Magnetsteller vorgesehen, der über eine Schaltstrecke des Hilfskreisschalters so gesteuert wird, daß dieser nur in der Nullstellung eine Arretierung des Meßbereichsschalters aufhebt. Vor einem Umschalten des Meßbereichsschalters auf eine andere Meßgröße muß somit der Eingangskreisschalter auf die Nullstellung zurückgeschaltet werden, bevor die Arretierung den Meßbereichsschalter freigibt.

Da bei Beginn einer jeden neuen Messung der Eingangskreisschalter in der Nullstellung stehen sollte, um ausgehend von dieser die jeweilige Meßgröbe am Eingangskreisschalter und auch am Meßbereichsschalter vorgeben zu können, ist es von Vorteil, wenn für eine automatische Rückstellung des Eingangskreisschalters gesorgt wird, sobald eine Messung abgeschlossen ist. Hierzu dient ein den Eingangskreisschalter in seine Nullstellung zurückführender Magnetsteller, der jeweils dann aktiviert wird, wenn ein das Eingangssignal überwachender Verstärker feststellt, daß das Eingangssignal weggefallen ist oder zumindest einen vernachlässigbaren Schwellwert unterschritten hat.

Die bereits beschriebene Möglichkeit bei einem Multimeter mit mehreren Eingangsanschlüssen Hilfskreise zu bilden, die eine Aktivierung von Magnetstellern ermöglichen, die ihrerseits zugehörige Eingangskreisschalter betätigen, kann auch so aufgebaut werden, daß den verschiedenen Eingangskreisen jeweils nur ein gemeinsamer Eingangsanschluß zugeordnet wird. In diesem Fall tritt an die Stelle der in die Eingangsanschlüsse integrierten Kontaktgeber ein Hilfsschalter mit einer Nullstellung und weiterer der Zahl der Kontaktgeber entsprechenden Schaltstellungen, derart, daß die als Umschalter wirkende Schaltstrecke des Hilfsschalters analog zu den Kontaktgebern jeweils nur einen Magnetsteller zur Aktivierung freigibt.

Dient im einfachsten Fall als Funktionsgeber eine Signallampe, so kann diese über entsprechende Hilfskreise einem bestimmten Eingangskreis derart zugeordnet werden, daß sich aus der Art und/oder räumlichen Zuordnung des optischen Signals ergibt, mit welchem Eingangskreis die Meßleitung nach entsprechender Positionierung des Meßbereichsschalters zu verbinden ist, sofern die Eingangskreise an unterschiedlichen Eingangsanschlüssen anliegen oder entsprechend umgeschaltet werden müssen.

Ausführungsbeispiele der Erfindung sind in den Zeichnungen dargestellt und werden im folgenden näher beschrieben.

Es zeigen:

Fig. 1    Prinzipschaltbild zur Sperrung von bestimmten Eingangsanschlüssen bei einem Multimeter mit mehreren Eingangsanschlüssen durch Sperriegel,

Fig. 2    Prinzipschaltbild zur Sperrung bestimmter Eingangskreise bei einem Multimeter mit zwei gemeinsamen Eingangsanschlüssen und handbetätigtem Eingangskreisschalter,

Fig. 3    Prinzipschaltbild zur Sperrung bestimmter Eingangskreise bei einem Multimeter mit mehreren Eingangsanschlüssen und gesteuerten Eingangskreisschaltern,

Fig. 4    Prinzipschaltbild zur Sperrung bestimmter Eingangskreise bei einem Multimeter mit zwei gemeinsamen Eingangsanschlüssen und gesteuerten Eingangskreischaltern,

Fig. 5    Prinzipschaltbild zur Signalisierung des richtigen, der Stellung des Meßbereichsschalters zugeordneten Eingangsanschlusses bei Multimetern mit mehreren Eingangsanschlüssen.

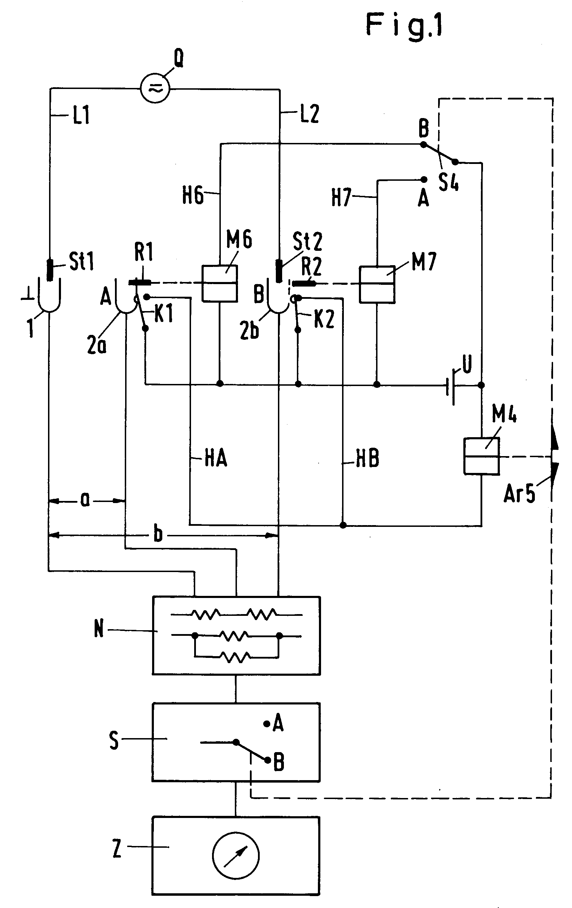

Das in Fig. 1 dargestellte Prinzipschaltbild zeigt ein Meßobjekt Q, z.B. eine Spannungsquelle, das über die Meßleitungen L1, L2 und Stecker ST1,ST2 mit Eingangsanschlüssen 1,2 des Multimeters verbunden ist. Das Multimeter besitzt zwei Eingangskreise a,b mit einem für beide gemeinsamen Eingangsanschluß 1 und spezifischen, den jeweiligen Eingangskreisen zugeordneten Eingangsanschlüssen 2a,2b. Der unterschiedliche Aufbau der Eingangskreise a, b soll durch das Meßbereichsnetzwerk N verdeutlicht werden, das z.B. aus Spannungsteilerwiderständen zur Spannungsumschaltung oder Shunts zur Stromumschaltung bestehen kann, und bei dem die Umschaltung durch einen Meßbereichsschalter S erfolgt. Das entsprechend angepaßte Meßsignal gelangt anschließend zu einem Meßsystem Z, das zur Meßwertverarbeitung und Anzeige dient.

Zwischen den Eingangsanschlüssen 2a,2b, denen jeweils die Meßgrößen A,B zugeordnet sind, und der diesen Meßgrößen zugeordneten Schaltstellung des Meßbereichsschalter S besteht ein Zusammenhang derart, daß die Meßleitung L2 unbedingt mit dem richtigen Eingangsanschluß 2a, 2b verbunden werden muß. Um den Benutzer daran zu hindern, diesbezüglich Fehler zu machen, sind die als Steckbuchsen ausgeführten Eingangsanschlüsse 2a,2b jeweils mit einem Sperriegel R1,R2 versehen, der über einen zugehörigen Magnetsteller M6,M7 in eine Sperrstellung gebracht werden kann, die den Eingangsanschluß vor einer Kontaktierung schützt. Die Steuerung des Magnetstellers M6,M7 erfolgt durch eine Schaltstrecke S4 des Meßbereichsschalters S, die über die Spannungsquelle U einen Hilfskreis H6 oder H7 einschaltet. Das Einschalten der Hilfskreise H6,H7 zur Aktivierung der Magnetsteller M6,M7 erfolgt somit in fester Kopplung mit der Meßgrößenumschaltung des Meßbereichsschalters S. Im vorliegenden Beispiel wurde durch den Meßbereichsschalter S die Meßgröße B vorgegeben, so daß die Schutzschaltung dafür sorgen muß, daß der der Meßgröße A zugeordnete Eingangsanschluß 2a gesperrt wird und der der Meßgröße B zugeordnete Eingangsanschluß 2b eine Kontaktierung ermöglicht. Die Steuerung der Magnetsteller M6,M7 soll nur das Prinzip verdeutlichen, sie kann selbstverständlich mit Ruhe oder Arbeitsstrom oder auch bei bistabilen Magnetstellern durch einzelne Steuerimpulse erfolgen.

Wesentlich für die Wirksamkeit der Schutzschaltung ist, daß diese bei angeschlossener Meßleitung L2 nicht durch Umschalten des Meßbereichsschalters S auf einen unzulässigen Meßbereich, außer Kraft gesetzt werden kann. Um dies zu erreichen, ist eine Arretiervorrichtung Ar5 vorgesehen, die bei Betätigung durch einen Magnetsteller M4 ein Weiterschalten des Meßbereichsschalters verhindert. Der Magnetsteller M4 wird durch einen Kontaktgeber K1,K2 gesteuert, der ebenfalls in die Steckbuchse des Eingangsanschlusses 2a,2b eingebaut ist und einen Hilfskreis HA,HB, in dem außer dem Magnetsteller M4 auch die Spannungsquelle U liegt, aktivieren kann. Die Auslösung dieser Aktivierung bewirkt der zweite Stecker ST2, der einen in die Steckbuchse 2b hineinragenden Nocken des Kontaktgebers K2 beim Einstecken verdrängt und dadurch den Kontakt schließt. Da sich die Arretierung Ar5 nur löst, wenn die Kontakte beider Kontaktgeber K1,K2 geöffnet sind, muß der Stecker ST2 aus der jeweiligen Steckbuchse 2a,2b herausgezogen werden, bevor der Meßbereichsschalter S umgeschaltet werden kann. Ein erneutes Einstecken des Steckers ST2 ist wiederum nur in die Steckbuchse möglich, die durch die zugehörigen Sperriegel R1, R2 nicht gesperrt wurde.

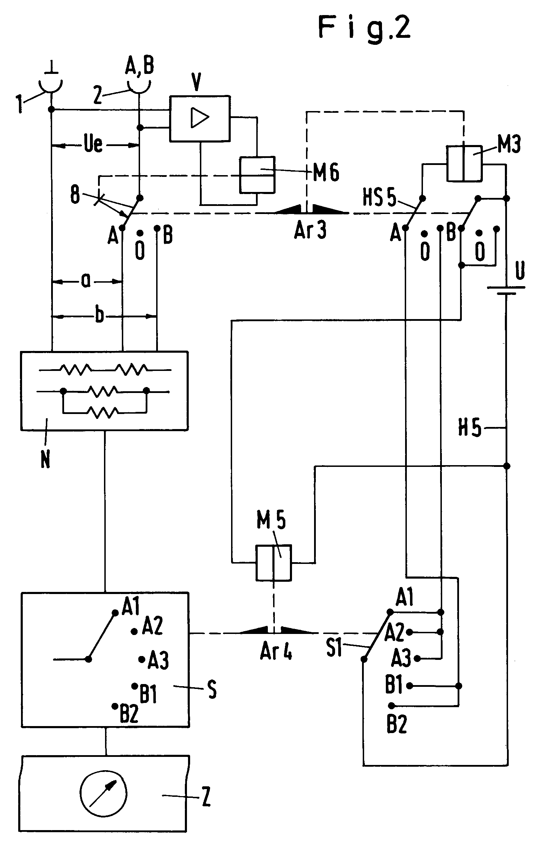

Das in Fig. 2 dargestellte Prinzipschaltbild entspricht soweit es den Multimeteraufbau betrifft, im wesentlichen dem in Fig. 1, unterscheidet sich aber dadurch, daß anstelle mehrerer spezifischer Eingangsanschlüsse 2a,2b für alle Eingangskreise a,b gemeinsame Eingangsanschlüsse 1,2 vorgesehen sind, so daß ein Umstecken von Meßleitungen L1,L2 entfällt. Als Ersatz für das Umstecken wurde ein Eingangskreisschalter 8 in die Schaltung eingefügt, der ausgehend von einer Nullstellung 0 auf eine Meßgröße A oder B und damit auf die Eingangskreise a,b umgeschaltet werden kann.

Ein zum Eingangskreisschalter 8 gehöriger oder mit diesem mechanisch gekoppelter Hilfskreisschalter HS5 wird ebenfalls ausgehend von einer Nullstellung 0 auf eine der Meßgröße A oder B zugeordnete Schaltstellung umgeschaltet. Zusammen mit einem in Reihe geschalteten Magnetsteller M3, einer Spannungsquelle U und einer Schaltstrecke S1 des Meßbereichsschalters S liegt er in einem Hilfskreis H5.

Der Meßbereichsschalter S erlaubt ein Umschalten zwischen den Meßgrößen A und B einerseits sowie zwischen verschiedenen Meßbereichen A1,A2,A3 der Meßgröße A und B1,B2 der Meßgröße B. Die von der Stellung des Meßbereichsschalters S abhängige Stellung der Schaltstrecke S1 ist mit dem Hilfskreisschalter HS5 so verbunden, daß der Magnetsteller M3 und die von ihm abhängige Arretierung Ar3 aktiviert wird, sobald der Hilfskreisschalter S5 auf eine andere Meßgröße geschaltet wird als die durch den Meßbereichsschalter S vorgegebene Meßgröße. Der Hilfskreisschalter HS5 ist dabei so ausgelegt, daß er bei dem Schaltvorgang dem Eingangskreisschalter 8 vorauseilt und beim Umschalten auf eine falsche Meßgröße die Arretierung Ar3 noch rechtzeitig wirksam wird, so daß sie ein Umschalten des Eingangskreisschalters auf eine falsche Meßgröße verhindert.

Bei den in Fig. 2 dargestellten Schaltstellungen stimmt die am Meßbereichsschalter S eingestellte Meßgröße A mit der am Eingangskreisschalter 8 eingestellten Meßgröße überein. Sollte jedoch versucht werden, den Eingangskreisschalter 8 auf die Meßgröße B umzuschalten, so würde über den voreilenden Hilfskreisschalter HS 5 der Magnetsteller M3 und damit die Arretierung Ar3 in einer Weise aktiviert, daß der Eingangskreisschalter 8 wieder in die Nullstellung 0 zurückgeschaltet werden müßte.

Die beschriebene Wirkungsweise der Schaltung gewährleistet, daß nach Vorgabe einer Meßgröße durch den Meßbereichsschalter S nur der Eingangskreis a,b eingeschaltet werden kann, dem die gleiche Meßgröße zugeordnet ist. Darüberhinaus soll jedoch sichergestellt sein, daß bei eingeschaltetem Eingangskreisschalter 8 und damit geschlossenem Eingangskreis a oder b der Meßbereichschalter S nicht auf eine andere Meßgröße umgeschaltet werden kann. Dies läßt sich mit Hilfe einer zweiten Schaltstrecke des Hilfskreisschalters HS5 erreichen, die in gleicher Weise, wie seine erste Schaltstrecke eine Nullstellung 0 besitzt, von der ausgehend auf eine der Meßgrößen A,B geschaltet werden kann. Über diese zweite Schaltstrecke wird ein weiterer Magnetsteller M5 mit Hilfe der Spannungsquelle U des Hilfskreises H5 gesteuert. Durch die Arretierung Ar4 sorgt er dafür, daß der Meßbereichsschalter S nur umgeschaltet werden kann, wenn sich der Eingangskreisschalter 8 in Nullstellung 0 befindet. Dem Benutzer des Multimeter ist es somit nicht möglich, aus Versehen bei eingeschaltetem Eigangskreisschalter den Meßbereichschalter S auf eine andere Meßgröße umzuschalten.

Trotz der getroffenen Maßnahmen zur Erhöhung der Bedienungssicherheit des Multimeters verbleibt die Möglichkeit, daß vor Inbetriebnahme des Multimeters bereits eine Meßgröße eingestellt wurde, die für das zu messende Meßsignal ungeeignet ist. Um den Benutzer vor dem Anschließen eines neuen Meßobjektes zur Überprüfung der Multimetereinstellung zu zwingen, ist ein weiterer Magnetsteller M6 vorgesehen, der mit Hilfe eines Verstärkers V das Meßsignal $U_e$ überwacht, und bei dessen Wegfall grundsätzlich eine Rückstellung des Eingangskreisschalters 8 in seine Nullstellung 0 bewirkt.

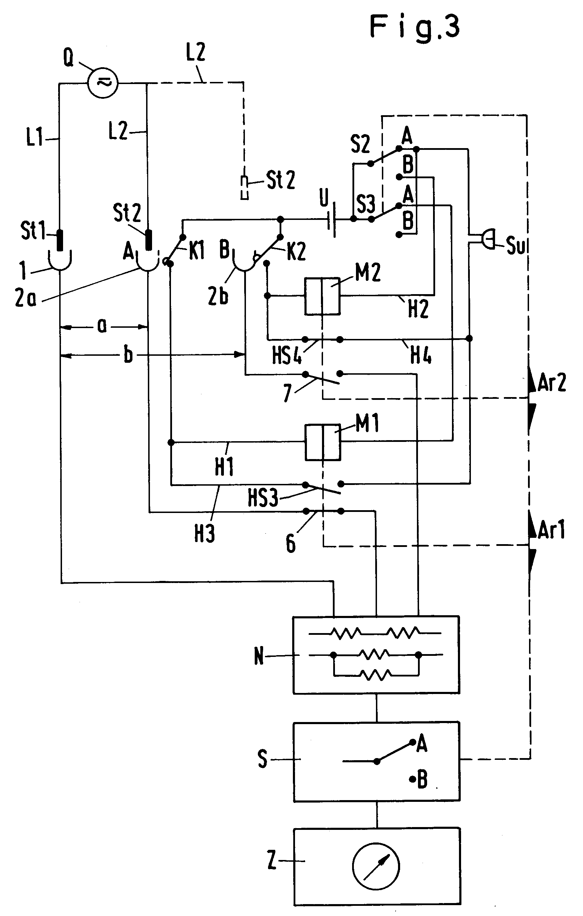

Bei dem Prinzipschaltbild nach Fig. 3 handelt es sich wiederum um ein Multimeter mit mehreren Eingangsanschlüssen 1,2a,2b entprechend dem bereits erläuterten Prinzipschaltbild nach Fig. 1. Auch im übrigen Aufbau, soweit er das Multimeter betrifft, stimmen die beiden Schaltbilder weitgehend überein, was auch durch gleiche Bezugszeichen verdeutlicht wird. Soweit jedoch die Schutzschaltung betroffen ist, gibt es bedeutsame Unterschiede, da nach Fig. 3 nicht mit Sperriegeln zum Blockieren der Eingangsanschlüsse 2a,2b gearbeitet wird, sondern die Unterbrechung oder Freigabe der Eingangskreise a,b durch Eingangskreisschalter 6,7 herbeigeführt wird. Die Betätigung der Eingangskreisschalter erfolgt wiederum in Abhängigkeit von der Schaltstellung des Meßbereichsschalters S derart, daß nur der Eingangskreisschalter 6,7 eingeschaltet wird, der in einem Eingangskreis a,b liegt, dem die am Meßbereichsschalter S eingestellte Meßgröße entspricht. Erreicht wird das mit zwei zum Meßbereichsschalter S gehörigen Schaltstrecken S2,S3, die zusammen mit je einem Magnetsteller M1,M2 in einem Hilfskreis H1,H2 liegen und zur Steuerung des jeweiligen Eingangskreisschalters 6,7 dienen.

Wesentlich für die Funktion der Schutzschaltung ist, daß zwischen dem Meßbereichsschalter S bzw. seinen Schaltstrecken S2,S3 keine starre Kopplung zu den Eingangskreisschaltern 6,7 besteht, derart, daß die den Meßgrößen A,B zugeordneten Eingangskreise a,b zwangsweise eingeschaltet wurden, sondern daß das Einschalten der Eingangskreisschalter 6,7 von einer weiteren Bedingung abhängt. Diese weitere Bedingung wird mit Hilfe von Kontaktgebern K1,K2 geschaffen, von denen jeweils einer elektrisch den Eingangskreisen H1,H2 und mechanisch den als Steckbuchsen ausgebildeten Eingangsanschlüssen 2a,2b zugeordnet ist. Die Kontaktgeber K1,K2 sind so in die Eingangsanschlüsse 2a,2b integriert, daß sie sich nur beim Einstecken eines Steckers ST2 schließen, z.B. indem der Stecker ST2 auf einen isolierenden Nocken des Kontaktgebers K1,K2 trifft, und diesen dabei soweit verdrängt, daß sich der Kontakt schließt. Bevor somit in den Hilfkreisen H1,H2 ein Strom fließen kann, der zu einer Aktivierung des Magnetstellers M1,M2 führen würde, muß gewährleistet sein, daß der Stecker ST2 den Eingangsanschluß 2a,2b kontaktiert hat, der für eine Eingangsgröße A,B vorgesehen ist, die zuvor bereits durch den Meßbereichsschalter S vorgegeben wurde.

Wie in dem Beispiel nach Fig. 3 dargestellt, kann der Magnetsteller M1 den Eingangskreischalter 6 nur einschalten, wenn der ihn aktivierende Hilfstromkreis H1 beim Kontaktieren des Eingangsanschlusses 2a durch den Kontaktgeber K1 geschlossen wird und die Schaltstrecke S3 sich wie der Meßbereichsschalter S in einer der Meßgröße A entsprechenden Stellung befindet. Hierdurch ist sichergestellt, daß ein Eingangsstrom nur in einem solchen Eingangskreis a, b fließen kann, der für die am Meßbereichsschalter S vorgegebene Meßgröße vorgesehen ist.

Die anhand des Beispiels in Fig. 3 beschriebenen Maßnahmen schließen jedoch die Möglichkeit nicht aus, den Stecker ST2 mit dem Eingangsanschluß 2b zu verbinden. Hierdurch würde zwar nicht der Eingangskreis b gefährdet, da die Schaltstrecke S2 geöffnet bleibt und der Magnetsteller M2 nicht zum Schließen des Eingangskreisschalters 7 aktiviert wird, dem Meßsystem Z würde jedoch das Fehlen eines Eingangssignals vorgetäuscht, was den Benutzer zu entsprechenden Fehlhandlungen verleiten könnte. Es wurden deshalb weitere Hilfskreis H3,H4 gebildet, die einerseits in Abhängigkeit von der Stellung des Magnetstellers M1,M2 und andererseits in Abhängigkeit von der Stellung des Kontaktgebers K1,K2 über die Schaltstrecken S2,S3 einen Signalgeber Su, vorzugsweise einen akustischen Signalgeber mit der Spannungsquelle U verbinden. Die Hilfskreise H3,H4 sind demnach so aufgebaut, daß der Signalgeber Su immer dann aktiviert wird, wenn ein Eingangsanschluß 2a,2b kontaktiert wird, dem eine Meßgröße zugeordnet ist, die nicht der am Meßbereichsschalter S eingestellten Meßgröße entspricht. Der Benutzer wird hierdurch zum Umstecken des Steckers S2 veranlaßt.

Eine weitere Gefahr besteht darin, daß bei richtig angeschlossener Meßleitung L2 und dementsprechend geschlossenem Eingangskreisschalter 6,7 der Meßbereichsschalter S bewußt oder versehentlich auf eine andere Meßgröße umgeschaltet wird. Die zuvor beschriebenen Sicherungsmaßnahmen würden zwar greifen, d.h. der Signalgeber Su würde aktiviert, und der Eingangskreisschalter des betroffenen Eingangskreises geöffnet, doch gerade letzteres ist unerwünscht, zumindest solange im Eingangskreis z.B. ein hoher Strom fließt, da in diesem Fall die Unterbrechung des Stromkreises die Kontakte des Eingangskreisschalters gefährden könnte. Um dieser Gefahr vorzubeugen, ist eine dem Magnetsteller M1 zugeordnete Arretierung Ar1 und eine dem Magnetsteller M2 zugeordnete Arretierung Ar2 vorgesehen. Die beiden Arretierungen Ar1 und Ar2 könnten auch zusammengefaßt werden, da sie beide auf den Meßbereichsschalter S einwirken und diesen solange arretieren, solange einer der beiden Eingangskreischalter 6,7 eingeschaltet ist. Das bedeutet, daß der Meßbereichsschalter S nur umgeschaltet werden kann, wenn der Stecker ST2 zum Umstecken in einen anderen Eingangsanschluß aus dem momentan kontaktierten Eingangsanschluß 2a,2b entfernt wird. Hierdurch ist gewährleistet, daß der Eingangskreisschalter 6,7 sich nur bei stromlosem Eingangskreis öffnet.

Auf Details, wie eine Arretierung des Meßbereichsschalters durchgeführt werden kann, soll hier nicht näher eingegangen werden, da sich eine große Zahl naheliegender Lösungsmöglichkeiten anbietet. Wesentlich ist jedoch, daß die Arretierung so ausgebildet wird, daß zwar nicht von einer Meßgröße auf eine andere Meßgröße umgeschaltet werden kann, wohl aber innerhalb verschiedener Meßbereiche derselben Meßgröße. Dies ist durch eine entsprechend codierte Mechanik ohne Schwierigkeiten erreichbar.

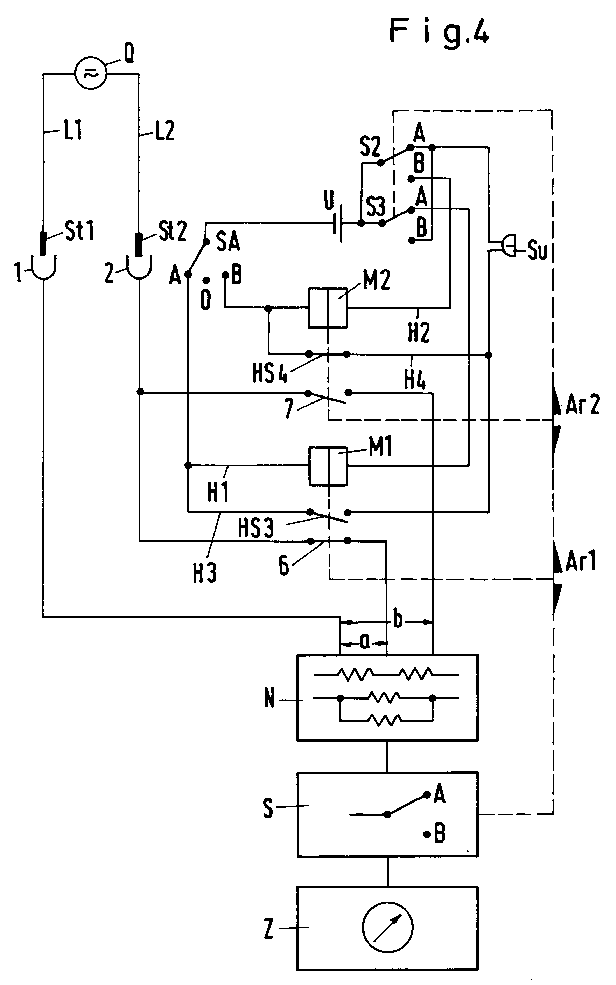

Die Benutzer von Multimetern empfinden das Umstecken der Meßleitung L2 in einen anderen Eingangsanschluß bei einem Wechsel der Meßgröße oft als lästig. Sie bevorzugen in der Regel Schalter zum Umschalten, die das Umstecken ersparen. Der Aufbau einer entsprechenden Schaltung analog zu der Schaltung nach Fig. 3 ist leicht realisierbar. Wie Fig. 4, zeigt ist an die Stelle der beiden Eingangsanschlüsse 2a,2b ein gemeinsamer Eingangsanschluß 2 getreten, was ohne weiteres möglich ist, da die Eingangskreisschalter 6,7 ein getrenntes Einschalten der Eingangskreise a,b erlauben. Der von der Schaltung nach Fig. 3 auf den Benutzer ausgeübte Zwang zu erhöhter Aufmerksamkeit, indem er sowohl bei Betätigung des Meßbereichsschalters S wie auch beim Kontaktieren der Meßleitung L2 auf die richtige Meßgröße A,B achten muß, kann in entsprechender Weise auch mit einem Hilfsschalter SA erreicht werden. Dieser tritt quasi an die Stelle der Kontaktgeber K1,K2 nach Fig. 3 und muß sich wie der Meßbereichsschalter S in einer einer bestimmten Meßgröße A,B zugeordneten Schaltstellung befinden.

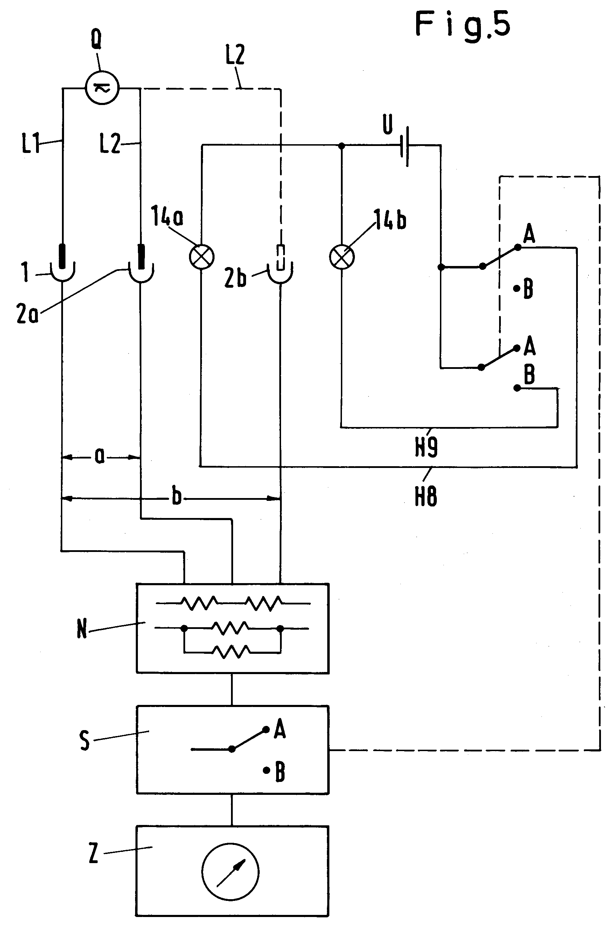

Eine besonders einfache Möglichkeit, den Benutzer eines Multimeters zu erhöhter Aufmerksamkeit beim Kontaktieren der Eingangsanschlüsse 2a,2b zu veranlassen, besteht nach Fig. 5 darin, über zusätzliche Schaltstrecken des Meßbereichsschalters S Signallampen 14a,14b so einzuschalten, daß erkennbar ist, welcher der Eingangsanschlüsse bei der jeweiligen Schaltstellung des Meßbereichsschalters S zu kontaktieren ist. Eine erhöhte Sicherheit gegenüber Fehlbedienungen wie nach den Schaltungen der Fig. 1 bis 4 ist hiermit allerdings nicht erzielbar.

**Patentansprüche**

1. Multimeter mit einem Meßbereichsschalter (S) zum wahlweisen Messen unterschiedlicher Meßgrößen (A,B), deren Meßsignale über verschiedene, jeweils einer bestimmten Meßgröße (A,B) zugeordnete Eingangskreise (a,b) vom Multimeter erfaßt werden und bei dem die Vorgabe einer bestimmten Meßgröße (A,B) mit Hilfe des Meßbereichsschalters (4) erfolgt, dadurch gekennzeichnet, daß mindestens ein Hilfskreis (H1-H9) gebildet und so über den Meßbereichsschalter (S) geführt ist, daß sich eine feste, von dessen Schaltstellung abhängige Zuordnung zu einem bestimmten Eingangskreis (a,b) und damit zu einer bestimmten Meßgröße (A,B) ergibt und in dem Hilfskreis (H1-H9) mindestens ein Funktionsgeber (M1-M7,14,Su) liegt, der bei Betätigung, die vorzugsweise durch Schließen des Hilfskreises (H1-H9) erreicht wird, eine Funktion oder eine Kombination aus mehreren Funktionen auslöst, die Bedienungsfehlern beim Umschalten der Meßgröße (A,B) entgegenwirkt. (Fig.1-5)

2. Multimeter nach Anspruch 1, dadurch gekennzeichnet, daß mindestens ein Funktionsgeber als Stellungsgeber, vorzugsweise Magnetsteller (M1-M7) ausgebildet ist und dieser mindestens einen Eingangskreisschalter (6,7) und/oder mindestens einen Hilfsschalter (HS3,HS4) und/oder mindestens eine Arretierung (Ar1-Ar5) und/oder mindestens einen Sperriegel (R1,R2) betätigt. (Fig. 1-4)

3. Multimeter nach mindestens einem der vorhergehenden Ansprüche, dadurch gekennzeichnet, daß ein Magnetsteller (M1,M2) den Eingangskreisschalter (6,7) in Abhängigkeit von einem Kontaktgeber (K1,K2) steuert, vorzugsweise derart, daß ein Schließen des Kontaktgebers (K1,K2) den Magnetsteller (M1,M2) aktiviert, der seinerseits den Eingangskreisschalter (6,7) schließt. (Fig.3)

4. Multimeter nach mindestens einem der vorhergehenden Ansprüche, dadurch gekennzeichnet, daß der Kontaktgeber (K1,K2) in Eingangsanschlüsse (1,2a,2b) eines Multimeters, vorzugsweise in eine Steckbuchse, integriert ist und beim Anschließen der Meßleitung (L1,L2) den Hilfskreis (H1-H4,HA,HB) öffnet oder vorzugsweise schließt und daß der Kontaktgeber (K1,K2) gegenüber dem jeweiligen Eingangskreis (a,b) elektrisch isoliert ist. (Fig.1 + 3)

5. Multimeter nach mindestens einem der vorhergehenden Ansprüche, dadurch gekennzeichnet, daß der Magnetsteller (M1,M2) außer dem Eingangskreisschalter (6,7) auch den Hilfsschalter (HS3,HS4) betätigt und beim Ansprechen des Magnetstellers (M1,M2) durch Anschließen einer Meßleitung (L1,L2) der Hilfsschalter (HS3,HS4) einen Signalgeber (Su), vorzugsweise einen Summer einschaltet und dieser ein Signal abgibt, wenn sich der Eingangskreisschalter (6,7) bei angeschlossener Meßleitung (L1,L2) nicht schließt, wobei letzteres ein Zeichen dafür ist, daß mit dem Meßbereichsschalter (S) eine andere Meßgröße (A,B) als durch Anschließen der Meßleitung (L1,L2) vorgegeben wurde. (Fig.3)

6. Multimeter nach mindestens einem der vorhergehenden Ansprüche, dadurch gekennzeichnet, daß ein Magnetsteller (M1-M5), gegebenenfalls der gleiche, der auch den Eingangskreisschalter (6,7) und den Hilfsschalter (HS3,HS4) betätigt, mit Hilfe einer Arretierung (Ar1-Ar5) den Meßbereichsschalter (S) vor unbeabsichtigtem Umschalten schützt, sobald ein Eingangskreis (a,b) geschlossen wird, dem die gleiche Meßgröße (A,B) zugeordnet ist wie die am Meßbereichsschalter (S) vorgegebene Meßgröße (A,B). (Fig.1-4)

7. Multimeter nach mindestens einem der vorhergehenden Ansprüche, dadurch gekennzeichnet, daß die Arretierung (Ar1-Ar5) jeweils mit einem ersten Arretierelement arbeitet, das an einem zweiten am beweglichen Teil des Meßbereichsschalters (S) ausgebildeten Arretierelement angreift und die Arretierelemente so positioniert sind, daß nach erfolgtem Eingriff ein Umschalten der Meßbereiche mit dem Meßbereichsschalter (S) nur im Bereich der gerade eingestellten Meßgröße (A,B) möglich ist. (Fig.1-4)

8. Multimeter nach mindestens einem der vorhergehenden Ansprüche, dadurch gekennzeichnet, daß der von einem Magnetsteller (M6,M7) betätigte Sperriegel (R1,R2) in mindestens einen der Eingangsanschlüsse (1,2a,2b) eingebaut ist und im Falle seines Auslösens ein Kontaktieren des jeweiligen Eingangsanschlusses (1,2a,2b) mit der Meßleitung (L1,L2) verhindert. (Fig.1)

9. Multimeter nach mindestens einem der vorhergehenden Ansprüche, dadurch gekennzeichnet, daß in mindestens einen der Eingangsanschlüsse (1,2a,2b), gegebenenfalls zusätzlich zu einem Sperriegel (R1,R2), der Kontaktgeber (K1,K2) eingebaut ist, und letzterer bei angeschlossener Meßleitung (L1,L2) über einen Magnetsteller (M1,M2,M4) eine Arretierung (Ar1,Ar2,Ar5) auslöst, die den Meßbereichsschalter (S) arretiert und bewirkt, daß dieser bei angeschlossener Meßleitung (L1,L2) nicht auf eine andere Meßgröße (A,B) umgeschaltet werden kann. (Fig.1 + 3)

10. Multimeter nach mindestens einem der vorhergehenden Ansprüche, dadurch gekennzeichnet, daß ein von Hand betätigbarer Eingangskreisschalter (8) mit einem in einem Hilfkreis (H5) liegenden Hilfskreisschalter (HS5) gekoppelt ist, und beide Schalter von einer Nullstellung (N) aus, je nach Schaltrichtung, auf eine andere Meßgröße (A,B) schaltbar sind, wobei der Hilfskreisschalter (HS5) beim Einschalten einer Meßgröße (A,B) soweit vorauseilt, daß ein im Hilfskreis (H5) liegender Magnetsteller (M3) über eine Arretierung (Ar3) den von Hand betätigbaren Eingangskreisschalter (8) gegen Einschalten sperrt, sofern der Meßbereichsschalter (S) auf einer anderen Meßgröße (A,B) steht als über den Eingangskreisschalter (8) eingestellt werden soll. (Fig.2)

11. Multimeter nach mindestens einem der vorhergehenden Ansprüche, dadurch gekennzeichnet, daß ein weiterer Magnetsteller (M5) über eine Schaltstrecke des Hilfsschalters (HS5) so gesteuert wird, daß dieser nur in der Nullstellung (0) eine Arretierung (Ar4) des Meßbereichsschalters (S) aufhebt, derart, daß gegebenenfalls vor dem Umschalten des Meßbereichsschalters (S) auf eine andere Meßgröße (A,B) der jeweilige Eingangskreis (a,b), vorzugsweise durch den Eingangskreisschalter (8) unterbrochen werden muß. (Fig.2)

12. Multimeter nach mindestens einem der vorhergehenden Ansprüche, dadurch gekennzeichnet, daß ein den Eingangskreisschalter (8) in seine Nullstellung (0) zurückführender Magnetsteller (M6) aktiviert wird, sobald ein das Eingangssignal ($U_e$) überwachender Verstärker (V) feststellt, daß das Eingangssignal ($U_e$) weggefallen ist oder zumindest einen vernachlässigbaren Schwellwert unterschritten hat. (Fig. 2)

13. Multimeter nach mindestens einem der vorhergehenden Ansprüche, dadurch gekennzeichnet, daß an die Stelle mehrerer Eingangsanschlüsse (2a,2b) nach Anspruch 4 ein gemeinsamer Eingangsanschluß (2) für mehrere Meßgrößen tritt und die Kontaktgeber (K1,K2) nach Anspruch 3 und 4 durch einen Hilfsschalter (SA) mit einer Nullstellung (0) und weiteren der Zahl der Kontaktgeber (K1,K2) entsprechende Schaltstellungen ersetzt sind, derart, daß die als Umschalter wirkende Schaltstrecke des Hilfsschalters (SA) wie die Kontaktgeber (K1,K2) nur jeweils einen Magnetsteller (M1,M2) zur Aktivierung freigeben. (Fig. 4)

14. Multimeter nach mindestens einem der vorhergehenden Ansprüche, dadurch gekennzeichnet, daß mindestens ein Funktionsgeber als Signallampe (14) ausgebildet und einem bestimmten Eingangskreis (a,b) derart zugeordnet ist, daß sich aus der Art und/oder räumlichen Zuordnung des optischen Signals ergibt, mit welchem Eingangskreis (a,b) die Meßleitung (L1,L2) nach entsprechender Positionierung des Meßbereichsschalters (S) verbunden ist oder, falls die Eingangskreise (a,b) an unterschiedlichen Eingangsanschlüssen (2a,2b) anliegen, verbunden werden muß. (Fig. 5)

# Fig.1

# Fig.2

# Fig.3

# Fig.4

# Fig.5